# NEUE EUROPÄISCHE PATENTSCHRIFT

(11) **EP 1 869 690 B2**
(45) Veröffentlichungstag und Bekanntmachung des Hinweises auf die Entscheidung über den Einspruch: **25.04.2018**
(45) Hinweis auf die Patenterteilung: 14.01.2015
(21) Anmeldenummer: 06705363.7
(22) Anmeldetag: 01.03.2006
(51) Int. Cl.: H01J 37/32, H01J 37/34, C23C 14/02, C23C 14/06, C23C 14/08, C23C 14/32, F01D 5/28

(54) **VERFAHREN ZUM BETREIBEN EINER GEPULSTEN ARCQUELLE**
METHOD FOR OPERATING A PULSED ARC SOURCE
PROCÉDÉ D'UTILISATION D'UNE SOURCE D'ARC PULSÉE

(30) Priorität: 24.03.2005 CH 518052005
(43) Veröffentlichungstag der Anmeldung: 26.12.2007
(60) Teilanmeldung: 11009905.8
(73) Patentinhaber: Oerlikon Surface Solutions AG, Trübbach, 9477 Trübbach (CH)
(72) Erfinder: RAMM, Jürgen, CH-7304 Maienfeld (CH); GSTOEHL, Oliver, FL-9496 Balzers (LI); WIDRIG, Beno, CH-7310 Bad Ragaz (CH); LENDI, Daniel, CH-9472 Grabs (CH)
(74) Vertreter: Keller & Partner Patentanwälte AG
(86) Internationale Anmeldenummer: PCT/CH2006/000123
(87) Internationale Veröffentlichungsnummer: WO 2006/099758

(56) Entgegenhaltungen:
- EP-A1- 0 462 303
- EP-A1- 0 564 789
- WO-A-02/070776
- CH-A5- 693 035
- DE-A1- 4 401 986
- DE-A1- 10 010 126
- JP-A- 1 042 574
- US-A- 4 645 895
- US-A1- 2003 209 424
- K. Keutel et al.: "Modified Pulse Arc Deposition for Reducing of Droplet Emission", Proceedings of the 18th International Symposium on Discharges and Electrical Insulation in Vacuum, Eindhoven 1998, IEEE, pages 562-565

## Beschreibung

### Technisches Gebiet

Die Erfindung betrifft ein Verfahren zum Betreiben einer Arcquelle gemäss dem Oberbegriff von Anspruch 1.

### Stand der Technik

Das Pulsen von Arcquellen ist aus dem Stand der Technik schon länger bekannt, so beispielsweise beschreibt WO 02/070776 sehr allgemein das Pulsen von Funkenquellen, um verschiedene Superhartschichten u.a. TiSiN abzuscheiden.

In WO 03/057939 ist eine Funkenquelle beschrieben, bei der das Zünden des Funkens über eine gepulste Hochspannungsversorgung, die Speisung des Funkens über eine gepulste Hochstromversorgung erfolgt. Der Betrieb des Funkens erfolgt hier diskontinuierlich. Ausgangsmaterialien sind metallisch leitenden Kathoden, leitfähige Legierungen und zusätzlich Kohlenstoff, beziehungsweise verdampfbare Halbleiter. Die hier gezeigte Arcquelle ist jedoch auf Grund der sehr komplexen Geometrie des Targetkörpers, besonders für schwer zu bearbeitende Kathodenmaterialien aufwändig zu fertigen und teuer im Betrieb.

In US 6,361,663 wird eine Arcquelle mit einer Kathode aus elektrisch leitfähigem Material beschrieben, die gepulst bzw. moduliert gepulst mit Spitzenströmen von bis zu 5 kA und einem Basisstrom von beispielsweise 100 A betrieben wird. Auch diese Quelle ist auf Grund ihrer Bauweise mit magnetischem Tunnel und einer von der Kathode vollständig umgebenen Anode aufwändig zu fertigen und teuer im Betrieb.

Auch die Abscheidung von elektrisch isolierenden Schichten mittels kathodischer Funkenverdampfung ist bereits bekannt, so beschreibt US 5,518,597 die Herstellung solcher Schichten in einem reaktiven Prozess. Dabei werden die zu beschichtenden Oberflächen ausserhalb einer optischen Verbindung zur aktiven Targetoberfläche, die hier als Synonym zur Verdampfungsoberfläche der Kathode gebraucht wird, angeordnet. Nach Abpumpen wird der Prozessdruck mit Inertgas eingestellt. Während der Beschichtung wird der Sauerstoff in unmittelbarer Nähe der zu beschichtenden Oberfläche und zwar nur mit einer solchen Rate eingelassen, dass es während der Operation verbraucht wird und ein stabiler Druck aufrechterhalten werden kann. Dies deckt sich mit der auch aus anderen Dokumenten des Standes der Technik bekannten Ansicht, dass der Einlass des Reaktivgases in der Nähe des Substrates wichtig ist, um die Oxidation des Targets zu reduzieren und die Funkenentladung zu stabilisieren. Als zusätzliche Massnahme, um Prozessunterbrechungen durch einen unerwünschten Aufbau isolierender Schichten auf der Anode zu vermeiden, wird diese in US 5,518,597 bevorzugt auf einer Temperatur bei ca. 1200°C gehalten und muss, d.h. aufwendig, aus teurem Refraktormetall gefertigt werden.

Die DE 44 01 986 A1 (VTD-Vakuumtechnik Dresden GmbH) beschreibt ein Verfahren zum Betreiben eines Vakuumlichtbogenverdampfers, wobei ein Grundstrom mit einem pulsierenden Strom überlagert wird, wodurch das Target gleichmässiger abgetragen und die Dropletbildung verringert wird. Dazu sind eine Gleichstromquelle für den Grundstrom und eine Pulsstromquelle für den pulsierenden Strom innerhalb der Stromversorgungseinrichtung parallel geschaltet, wobei die Gleichstromquelle und die Pulsstromquelle von einer Steuereinrichtung mit eingebautem Mikrorechner gesteuert werden. Es wurde festgestellt, dass der Grundstrom auf einen Wert abgesenkt werden kann, der unter jenem Wert liegt, der ohne pulsierenden Strom zur Aufrechterhaltung einer stabilen Bogenentladung erforderlich ist. Als Targetmaterial können Metalle der Gruppen IV, V und VI gewählt werden. In den Ausführungsbeispielen werden insbesondere Titan und Titan zusammen mit Aluminium als Targetmaterial gewählt, wobei Titan und Aluminium in koaxialen rotationssymmetrischen Bereichen angeordnet sind und die Abtragung in einer Stickstoff-Atmosphäre stattfindet.

Da in der DE 44 01 986 A1 nur leitende Schichten und keine isolierende Schichten aufgetragen werden, kann sich auf dem Target auch keine Isolierbelegung bilden. Das heisst, einen Betrieb im vergifteten Bereich ist nicht möglich. Daher geht aus der DE 44 01 986 A1 auch nicht hervor, welche Auswirkung eine Isolierbelegung auf dem Target für den Betrieb einer Arcquelle hat.

All diesen Verfahren ist gemeinsam, dass bei Verwendung von Reaktivgasen, die mit dem bzw. den verdampften Materialien rasch unter Bildung einer isolierenden Schicht reagieren, besondere Massnahmen zu treffen sind, um einerseits die aktive Oberfläche des Targets bzw. der Anode nicht zu vergiften, andererseits die Bildung von unerwünschten Droplets zu vermeiden. Solche Massnahmen umfassen, neben dem erwähnten Beheizen der Anode und der Zufuhr und genauen Dosierung des Reaktivgases in unmittelbare Nähe der zu beschichtenden Oberfläche, eine Verdünnung des Reaktivgases mit einem hohen Anteil an Inertgas.

Insbesondere ist dabei darauf zu achten, dass die Oberfläche des Targets metallisch blank oder zumindest eine einem Halbleiter entsprechende Leitfähigkeit behält. Durch den positiven Temperaturgradienten von Halbleitern ist im Bereich des Arcspots zwar eine ausreichend gute Leitfähigkeit vorhanden, um den Funken brennen zu lassen, jedoch kommt es durch die damit einhergehende erhöhte Neigung zum Festbrennen des Funkens üblicherweise zu einer höheren Spritzerbildung als bei metallisch leitenden Targetoberflächen. Auch dazu sind aus dem Stand der Technik eine Reihe von Möglichkeiten bekannt. Beispielsweise können die Quellen wie oben erwähnt ausserhalb der optischen Verbindungslinie zur Targetoberfläche angeordnet werden, was jedoch die Ausbeute des Targetmaterials bzw. die Beschichtungsrate drastisch einschränkt. Es können zusätzlich oder allein magnetische Felder angelegt werden, die nur den ionisierten Dampfanteil auf die zu beschichtenden Oberflächen leiten, während elektrisch neutrale Droplets auf Prallflächen abgefangen werden. Beispiele dafür sind gekrümmte Magnetfilter, magnetische Linsen und ähnliches.

Eine weitere Methode Spritzer zu reduzieren, besteht aus einem kurzzeitigen Unterbrechen der Stromzufuhr, wobei der Funken, beispielsweise über einen Laserstrahl gesteuert, jeweils an einem anderen Ort der aktiven Targetoberfläche wieder gezündet wird. Diese Methode wird vor allem im Gebiet der kathodischen Funkenverdampfung von Kohlenstoff aber auch für Legierungen aus Metall angewendet.

All diesen Massnahmen, bzw. den ebenso bekannten Kombinationen dieser Massnahmen, ist ein zusätzlicher beträchtlicher technischer Aufwand und/oder eine wesentliche Verringerung der Beschichtungsrate gemein. Kommt es jedoch auf der Targetoberfläche zur Ausbildung einer Isolierbelegung, so konnte bis jetzt auch mit oben angegebenen Massnahmen kein stabiler Prozess gefahren werden.

### Darstellung der Erfindung

Eine Aufgabe der vorliegenden Erfindung besteht daher darin ein Verfahren zur Verfügung zu stellen, mit dem auch isolierende Schichten mit üblichen Arcquellen ohne aufwendige zusätzliche Massnahmen unter stabilen Prozessbedingungen hergestellt werden können.

Diese Aufgabe wird gelöst durch ein Verfahren nach Anspruch 1.

überraschenderweise konnte gezeigt werden, dass bei gleichzeitigem Anlagen eines Gleichstroms, der mit einem Puls- bzw, Wechselstrom überlagert ist, ein stabiler Arcprozess auch dann betrieben werden kann, wenn die Targetoberfläche zumindest teilweise durch eine Isolierbelegung bedeckt ist.

Beispielsweise konnte so ohne weitere zusätzliche Massnahmen ein Aluminiumtarget mehrere Stunden lang in einer reinen Sauerstoffatmosphäre betrieben werden. Dabei wurde ein Anstieg der Spannung am Target beobachtet, dieser Anstieg stabilisierte sich aber innerhalb Minuten und führte nicht zum Unterbruch oder zur Instabilität des Arcprozesses. Die dabei auf einem direkt vor dem Target positioniertem Substrat abgeschiedene Aluminiumoxidschicht zeigte eine gegenüber einer unter gleichen Bedingungen abgeschiedenen metallischen Aluminiumschicht völlig unerwartete deutliche Reduktion der Oberflächenfehler durch anhaftende Droplets. In allen Fällen konnten die Targets nach einer vollständigen Isolierbelegung der Oberfläche auch nach Prozessunterbrechungen problemlos unter Reaktivgasatmosphäre wieder gezündet und mit verringerter Dropletbildung betrieben werden. Der Betrieb in reiner Reaktivgasatmosphäre bzw. mit der Belegung der Targetoberfläche durch das Reaktivgas bzw. dessen Reaktion mit derTargetoberfläche, führten in diesem Pulsmode zu erhöhter Schichtqualität mit verminderter Dropletbildung.

Gegenüber dem Betrieb der Targets ohne Isolierbelegung, konnte festgestellt werden, dass der Anteil des Reaktivgases zumindest so hoch gewählt werden sollte, dass die Quellenspannung im Vergleich zum Betrieb ohne Isolierbelegung um mindestens 20% zunimmt. Der Anstieg der Quellenspannung ist grundsätzlich vom verwendeten Reaktivgas und dem Targetmaterial abhängig. Je höher die Isoliereigenschaften der aus dem Targetmaterial und dem Reaktivgas an der Targetoberfläche hergestellten Verbindung bzw. Verbindungen ist, desto grösser wird üblicherweise die Differenz der Quellenspannung, auch wenn hier auf Grund zahlreicher oberflächen- und materialspezifischer Reaktionsmuster bzw. -hemmungen nicht ohne Weiteres ein direkter mathematischer Zusammenhang herstellbar ist.

Das Reaktivgase ist Sauerstoff. Besonders geeignet ist dieses Verfahren für Prozesse mit hohen Reaktivgasflüssen, bei denen der Anteil des Reaktivgases grösser als der des Inertgases beispielsweise über 70% insbesondere über 90% gewählt wird. Doch können auch wie oben erwähnt Prozesse in reiner, also 100% Reaktivgas enthaltender Atmosphäre vorteilhaft gefahren werden.

Das Targetmatetrial ist Aluminium, das mit obengenanntem Gasen auf der Oberfläche eines wie oben betriebenen Targets eine entsprechende Isolierbelegung aus einem Oxid ausbildet.

Zur weiteren Verminderung der Spritzer, insbesondere beim Betrieb eines Targets unter sauerstoffhaltiger Atmosphäre, kann es, wie in US 6,602,390 offenbart, von Vorteil sein, dass das Targetmaterial aus einer einzigen kristallographischen Phase besteht.

Ein weiterer Vorteil aus dem gleichzeitigen Betreiben einer Arcquelle mit einem Gleichstrom sowie mit einem Puls- bzw. Wechselstrom ergibt sich beim Beschichten von temperaturempfindlichen Werkstücken, wie zum Beispiel gehärteten Stählen, Auslagerungslegierungen auf Bronze und Messingbasis, Aluminium-Magnesiumlegierungen, Kunststoffen und anderen. Bei einem DC-Betrieb einer oder mehrerer Arcquellen in der Nähe des Haltestroms, das ist der kleinste Strom bei dem noch ein stabiles Betreiben einer elektrisch leitenden Arcquelle mit einer einfachen DC-Stromversorgung möglich ist, ist die Temperaturbelastung der zu beschichtenden Werkstücke zwar gering, gleichzeitig aber die Beschichtungsrate für industrielle Anwendungen wenig befriedigend. Der Wert des Haltestroms bzw. der Halteleistung hängt dabei vom Targetmaterial, von der Bauart der Arcquelle bzw. vom Betrieb der Entladung ab, beispielsweise ob diese unter Vakuum mit oder ohne Zugabe von Inert- bzw. Reaktivgas betrieben wird. Eine ausreichende Leitfähigkeit, um einen stabilen Betrieb bei kleinen Strömen zu gewährleisten, haben beispielsweise metallisch blanke Oberflächen aber auch Verbindungen wie WC, TiN oder CrN. Graphit- bzw. Siliziumtargets bilden hier einen Grenzfall, da einerseits deren Leitfähigkeit zwar noch ausreicht um sie mittels DC-Arc zu verdampfen, andererseits dabei aber eine starke Tendenz zu einem lokalen Einbrennen des Funkens festzustellen ist, wodurch es zu Plasmaschwankungen und starker Dropletbildung kommt, weshalb beispielsweise Graphittargets heute bevorzugt gepulst betrieben werden.

Wird eine Quelle hingegen in der Nähe des DC-Haltestroms betrieben und gleichzeitig mit einem Pulsstrom überlagert, konnte überraschenderweise nicht nur die Rate wesentlich erhöht werden sondern auch die Temperaturbelastung gegenüber einer DC-Beschichtung mit vergleichbarer Rate gering gehalten werden. Vorteilhafterweise wird dabei der DC-Anteil bei 100 bis 300%, bevorzugt zwischen 100 bis 200% des Haltestroms, bzw. der Halteleistung eingestellt.

Ein solcher Prozentsatz des Haltestroms entspricht bei den wie unten näher beschriebenen Quellen einem DC-Anteil des Stromflusses in einem Bereich zwischen 30 und 90 A, bevorzugt zwischen 30 und 60 A. Dabei kann die Arcquelle mit einem Prozessgas, das nur Reaktivgas oder eine Mischung aus Reaktivgas und Inertgas enthält betrieben werden.

Das Anlegen bzw. Erzeugen der verschiedenen Stromanteile kann dabei in bekannter Art und Weise erfolgen. Beispielsweise kann der Gleichstromanteil durch einen Gleichstromgenerator, der Puls- bzw. Wechselstromanteil durch eine Puls- bzw. Wechselstromgenerator erzeugt werden, wobei beide Generatoren entweder parallel oder in Serie zwischen Arcquelle und zumindest einer Anode bzw. Masse geschaltet werden.

Eine andere Möglichkeit ist es, den Gleich- und Pulsstromanteil durch zwei ebenso geschaltete, überlagert und synchronisiert betriebene Puls- bzw. Wechselstromgeneratoren zu erzeugen. Weiters ist es schliesslich auch möglich den Gleich- und Pulsstromanteil durch einen einzelnen Stromgenerator zu erzeugen, der sekundär oder primär getaktet wird.

Für industrielle Anwendungen ist ein solches Vorgehen besonders interessant, wenn beispielsweise Werkstücke, an die besondere Anforderungen betreffs Verschleissbeständigkeit gestellt werden, bzw. Werkstücke deren Oberfläche isolierende oder dekorative Eigenschaften aufweisen sollen, zu beschichten sind. Ein Schichtbeispiele für das sich solche Verfahren besonders eignet ist Aluminiumoxid.

Das genannte Material kann als Einzelschicht oder als eine Abfolge von zwei oder mehreren bezüglich der elementaren Zusammensetzung, der Stöchiometrie oder der kristallographischen Ausrichtung variierten Schichten abgeschieden werden, wobei die Schichtdicke der einzelnen Schichtlagen nach Bedarf zwischen wenigen Nanometern und einigen Mikrometern eingestellt werden kann. Zusätzlich können, wie dem Fachmann bekannt, beispielsweise metallische oder nitridische Haftschichten oder Anpassungsschichten aus unterschiedlichen Verbindungen, die beispielsweise einen gradierten Übergang vom Substratmaterial des Werkstücks zum Schichtmaterial ermöglichen, vor den oben angeführten Schichten abgeschieden werden. Bekannte Haftschichten sind beispielsweise Cr, Ti, CrN oder TiN. Anpassungsschichten werden unter Beispiel 1 aufgeführt.

Zusätzlich kann bei solchen Verfahren vorteilhaft ein DC-, ein Puls- oder ein Wechselstrombias angelegt werden, der bei Bedarf mit dem Puls- bzw. Wechselstromgenerator der Quelle synchronisiert wird.

Ein weiteres Anwendungsfeld für solche Verfahren ist die Beschichtung von Werkstücken aus Silizium oder anderen halbleitenden Materialen.

Es hat sich gezeigt, dass die Beschichtung im beschriebenen Pulsmode auch für isolierende Substrate geeignet ist, bei denen kein DC Substratbias bzw. ein DC gepulster Substratbias mit kleineren oder mittleren Frequenzen sinnvoll ist.

Mit einem wie oben beschriebenen Verfahren können schlagwortartig zusammengefasst folgende weitere vorteilhafte Wirkungen erzielt werden:
1. Ein stabiler Prozess zur Herstellung isolierender Schichten mittels Funkenverdampfung ohne dass es zu einer Spritzerbildung kommt, die eine Durchoxidation/-reaktion der Schicht verhindert.
2. Erstmals ist ein Arbeiten mit einem vollständig vergifteten Funkentarget möglich. Die Reaktivität, d.h. das Angebot der reaktiven Komponente Sauerstoff bei der Abscheidung von Aluminiumoxid, kann durch das Arbeiten im voll vergifteten Mode bzw. in reiner Reaktivgasatmosphäre erhöht und damit einhergehend ein grösseres Schichtwachstum erzielt werden.
3. Es ist weder eine örtliche oder Druckstufentrennung von Target und Reaktionsraum noch eine aufwendige Trennung von Spritzern und ionisiertem Dampf notwendig.
4. Die Funkenführung kann ohne zusätzliche Magnetfeldunterstützung erfolgen.
5. Eine Reduktion der Zahl und Grösse der Spritzer auch bei vergiftetem Target.
6. Durch den modulierten Pulsbetrieb wird das Arbeiten mit höheren Strömen möglich, was zu einer grösseren Ionisierung bei gleichbleibender oder sogar verringerter thermischen Belastung des Targets führt.
7. Ein gleichmässigerer Abtrag von leitenden und nichtleitenden Oberflächen des Aluminiumtargets.
8. Eine feinere Aufteilung des Funkens, d.h. viele kleine und schnell über die Oberfläche laufende Arcspots.
9. Die Erzielung einer höheren Ionisierung durch Anwendung von Hochstrom pulsen und damit verbundene Erhöhung des Substratstroms.
10. Die Prozessführung bei der reaktiven Funkenverdampfung wird unabhängig von der Targetbelegung durch isolierende Schichten. Das erlaubt eine Mischung von Reaktivgasen und erlaubt das Fahren von Rampen bei reaktiven Prozessen, was sowohl bei der Zwischenschicht wie der Funktionsschicht von Vorteil ist.
11. Eine Erhöhung der Prozessstabilität und breiteres Prozessfenster.
12. Die Verwendung von bekannten Stromversorgungen, die einen weiten Bereich von Spezifikationen in Strom und Spannung zulassen (vielfältige ökonomische Kombinationen möglich, bspw. billige DC-Stromversorgung für Gnmdlast).
13. Die Erfindung stellt sicher, dass das Plasma nicht unterbrochen wird und damit das ein wiederholtes bzw. periodisches Neuzünden mit der erforderlich aufwendigen Technik nicht mehr erforderlich ist.
14. Eine Kombination des Verfahrens mit zusätzlichen Plasmaquellen ist möglich; hier sei insbesondere eine zusätzliche Anregung durch einen gleichzeitig betriebenen Niedervoltbogen erwähnt, womit eine zusätzliche Erhöhung der Reaktivität bei der Schichtabscheidung am Substrat erreicht wird.

### Wege zur Ausführung der Erfindung

Im Folgenden wird ein typischer Ablauf eines erfindungsgemässen Beschichtungsverfahrens mit einem reaktiven Funkenbeschichtungsprozess geschildert. Auf diese Weise wurden in einer industriellen Beschichtungsanlage vom Typ RCS der Firma Balzers, wie beispielsweise in EP 1 186 681 in Fig. 3 bis 6, Beschreibung Spalte 7, Zeile 18, bis Spalte 9, Zeile 25, beschrieben, entsprechend dem folgenden im Detail beschriebenen Beispiel Aluminiumoxid auf verschiedenen Werkstücken abgeschieden.

Neben dem eigentlichen Beschichtungsprozess wird, wo notwendig, auch kurz auf weitere Prozessschritte eingegangen, die die Vor- und Nachbehandlung der Substrate betreffen. Viele dieser Schritte, wie beispielsweise die Reinigung der Substrate, die je nach Material und Vorbehandlung verschieden durchgeführt wird, lassen, wie dem Fachmann bekannt, breite Variationen zu, einige können unter bestimmten Bedingungen auch weggelassen, verkürzt, verlängert oder anders kombiniert werden.

### Beispiel 1

Nach Einlegen der Werkstücke in dafür vorgesehenen zwei- oder dreifach rotierbare Halterungen und Einbringen der Halterungen in die Vakuumbehandlungsanlage, wird die Behandlungskammer auf einen Druck von ca. 10⁻⁴ mbar abgepumpt.

Zur Einstellung der Prozesstemperatur wurde ein durch Strahlungsheizungen unterstütztes Niedervoltbogen(NVB)plasma zwischen einer durch eine Blende abgetrennte Kathodenkammer mit Heisskathode und den anodisch geschalteten Werkstücken in einer Argon-Wasserstoffatmosphäre gezündet.

Dabei wurden folgende Heizparameter eingestellt:

| | |
|---|---|
| Entladestrom NVB | 150 A |
| Argonfluss | 50 sccm |
| Wasserstofffluss | 300 sccm |
| Prozessdruck | 1.4x10⁻² mbar |
| Substrattemperatur | ca. 500°C |
| Prozesszeit | 45 min |

Alternativen dazu sind dem Fachmann bekannt. Die Substrate wurden dabei bevorzugt als Anode für den Niedervoltbogen geschaltet und bevorzugt zusätzlich unipolar oder bipolar gepulst.

Als nächster Prozessschritt wird das Aetzen gestartet. Dafür wird der Niedervoltbogen zwischen dem Filament und der Hilfsanode betrieben. Auch hier kann eine DC, eine gepulste DC oder eine mit Wechselstrom betriebene MF oder RF Versorgung zwischen Werkstücken und Masse geschaltet werden. Bevorzugt wurden die Werkstücke aber mit einer negativen Biasspannung beaufschlagt.

Dabei wurden folgende Ätzparameter eingestellt:

| | |
|---|---|
| Argonfluss | 60 sccm |
| Prozessdruck | 2.4x10⁻³ mbar |
| Entladestrom NVB | 150 A |
| Substrattemperatur | ca. 500°C |
| Prozesszeit | 30 min |

Um die Stabilität der Niedervoltbogenentladung bei der Herstellung isolierender Schichten zu gewährleisten, wird bei allen NVB-unterstützten Prozesschritten entweder mit einer heissen, leitfähigen Hilfsanode gearbeitet oder eine gepulste Hochstromversorgung zwischen Hilfsanode und Masse geschaltet.

Zur Erhöhung der Haftfestigkeit wird eine ca. 300 nm dicke CrN Schicht mittels Funkenverdampfung aufgebracht, die bei Bedarf an zusätzlicher Ionisation noch durch das Plasma des Niedervoltbogens unterstützt werden kann.

Dabei wurden folgende Zwischenschichtparameter eingestellt:

| | |
|---|---|
| Argonfluss | 80 sccm |
| Stickstofffluss | 200 sccm |
| Prozessdruck | 8x10·3 mbar |
| DC Quellenstrom Cr | 140 A |
| Substratbias | von -100V auf -40V bipolar 36 µs negativer und 4 µs positiver Bias |
| Substrattemperatur | ca. 500°C |
| Prozesszeit | 10 min |

Für den ca. 5 min langen Übergang zur eigentlichen Funktionsschicht werden die Aluminium-Arcquellen mit einem DC-Quellenstrom von 60 A zugeschaltet, wobei der positive Pol der DC-Quelle mit dem Anodenring und Masse verbunden ist. Zusätzlich erfolgt eine Ueberlagerung mit unipolaren DC Pulsen einer zweiten, parallel geschalteten Stromversorgung, die mit 50 kHz betrieben wird. Im vorliegenden Beispiel wurde mit einem symmetrischen Tast/Pauseverhältnis von 10 µs Puls/10 µs Pause gearbeitet und in den Pulsen Ströme bis 150 A generiert. Dann erfolgt der Einlass des Sauerstoffs mit 300 sccm, bzw. gemäss den in der Tabelle angegebenen Parametern.

Nach Hochfahren der Al Targets und Einstellen des Sauerstoffflusses, wird der Quellenstrom am Cr Target über eine Rampe in ca. 10 min auf Null zurückgefahren und gleichzeitig der N₂ Fluss reduziert. Anschliessend wird der Ar Fluss auf Null gefahren.

Die Beschichtung der Substrate mit der eigentlichen Funktionsschicht erfolgt im reinen Reaktivgas Sauerstoff. Da es sich bei Aluminiumoxid um isolierende Schichten handelt, wird entweder eine gepulste oder AC Biasversorgung verwendet.

Die wesentlichen Funktionsschichtparameter wurden dabei wie folgt eingestellt:

| | |
|---|---|
| Sauerstofffluss | 300 sccm |
| Prozessdruck | 9x10³ mbar |
| DC Quellenstrom Al | 60A |
| Puls-Quellenstrom Al | 150 A, 50 kHz, 1 Oµs Puls/10 µs Pause |
| Substratbias | bleibt auf -40 V DG gepulst oder AC Ueweils 50 - 350 kHz) |
| Substrattemperatur | ca. 500°C |
| Prozesszeit | 60 bis 120 min, einzelne Versuche mit 360 min |

Die Beschichtung kann auch simultan mit gezündetem Niedervoltbogen erfolgen. In diesem Falle wird eine höhere Reaktivität erzielt. Ausserdem hat die simultane Benutzung des Niedervoltbogens während der Beschichtung auch noch den Vorteil, dass der DC Anteil der Quellen, je nach Grösse des NVB-Stroms weiter reduziert werden kann.

Der so geführte Beschichtungsprozess ist stabil über mehrere Stunden. Das Target bedeckt sich mit einer dünnen, glatten Oxidschicht. Der Funken läuft ruhiger als bei einem Betrieb ohne zusätzliches Pulssignal und teilt sich in mehrere kleinere Funken auf. Die Spritzerzahl wird wesentlich reduziert.

Als Arcquellen wurden für die Haftschicht ebenso wie für die Funktionsschicht, Arcquellen der Firma Balzers mit einem Targetdurchmesser von 160 mm und einer Dicke von 6 mm, mit einem Standard MAG 6-Magnetsystem verwendet. Prinzipiell kann jedoch jede bekannte Quelle mit einem solchen Prozess gefahren werden, sofern eine entsprechende Stromversorgungseinheit angeschlossen wird.

Der beschriebene Prozess ist die bevorzugte Version, da er die Anforderungen an die gepulste Stromversorgung gering hält. Die DC-Versorgung liefert den Mindest- oder Haltestrom für den Funken und die gepulste Hochstromversorgung dient zur Vermeidung der Spritzer.

Weitere Beispiele für die Abscheidungsparameter von Funktionsschichten sind in Tabelle 1 näher beschrieben. Zunächst wurden im Wesentlichen dieselben Reinigungs, Heiz- und Ätzschritte vorgenommen, sowie eine Zwischenschicht aus CrN bzw. TiN entsprechend Beispiel 1 abgeschieden. Anschliessend wurde die Funktionsschicht aus Aluminiumoxid entsprechend den Angaben in der Tabelle hergestellt.

Zum Vergleich des Einflusses der Quellenspannung durch die Bedeckung mit einer Isolierbelegung wurde im Beispiel 2 eine rein metallische Schicht abgeschieden. Dabei zeigt sich, dass es vor allem bei einer Belegung mit hoch isolierenden oxydischen Schichten zu einem starken Anstieg des DC-Anteils der Quellenspannung kommt. Hier beträgt der relative Spannungsanstieg schon bei verhältnismässig geringen Zugaben an sauerstoffhaltigem Reaktivgas zwischen ca. 20 und 50% des Werts der unter reinem Inertgas betriebenen metallisch blanken Quelle. Auch bei einem Betrieb mit Stickstoff kommt es zu einem Anstieg der Quellespannung, der jedoch geringere Werte, etwa zwischen ca. 10 und maximal 30%, aufweist. In allen Fällen kommt es zwar durch das gleichzeitige Anlegen einer Pulsspannung zu einer geringfügigen Absenkung der DC-Quellenspannung gegenüber dem reinen DC-Betrieb, der ursprüngliche niedrigere Spannungszustand einer metallisch blanken Quelle wird jedoch in keinem Fall wieder erreicht.

Der bevorzugte Frequenzbereich in dem die Arcquelle betrieben wird liegt ist zwischen 5 und 50 kHz. Bei Bedarf kann die Quelle aber auch bei niedrigeren Frequenzen etwa bis 0,5 kHz, oder hohen Frequenzen bis 1 MHz betrieben werden. Bei noch niedrigeren Frequenzen wird der Betrieb bei der Abscheidung von isolierenden Schichten instabil, bei höheren Frequenzen steigen die Generatorkosten extrem an.

Sind zusätzliche Anpassungsschichten erwünscht oder notwendig, so können diese statt der CrN-oder anderen Haftschichten bzw. zwischen Haftschicht und Funktionsschicht aufgebracht werden. Beispiele dafür, die neben den bereits erwähnten auch bei der Abscheidung von oxydischen Deckschichten vorteilhaft sein können, sind die Oxykarbide von Titan und Chrom, sowie die Oxynitride, Oxysilicide, Oxysiliconitride, bzw. Siliconitride von Aluminium, Chrom, Titan, Tantal, Niob oder Zr.

Trotz der hervorragenden Haftfestigkeit von mittels kathodischer Funkenverdampfung hergestellten Haft bzw. Anpassungsschichten, können diese wie dem Fachmann bekannt auch mittels anderer Beschichtungstechniken wie zum Beispiel CVD, PECVD, Sputtern oder der Verdampfung mittels Niedervoltbogen aus einem anodisch geschaltetem Tiegel, erfolgen. Hier ist prinzipiell jede Kombination verschiedener Techniken möglich wobei jedoch plasmaunterstützte Prozesse, die eine hohe Ionisation gewährleisten, auf Grund der damit erzielbaren besseren Haftung bevorzugt sind.

### Kurze Beschreibung der Zeichnungen

Im Folgenden werden Gegenstände, mit welchen die Erfindung ausgerührt werden kann, erläutert. Es zeigen
- **Fig.1**: eine Vakuumbehandlungsanlage mit Arcquelle
- **Fig.2**: parallel geschaltete DC- & Pulsstromversorgung
- **Fig.3**: Targetoberflächen
- **Fig.4**: zwei parallel geschaltete Pulsstromversorgung
- **Fig.5**: eine Multianodenanordnung
- **Fig.6**: Stromversorgungen in Serienschaltung
- **Fig.7**: Stromversorgungen mit Kurzschlussschaltung
- **Fig.8**: eine sekundär getaktete Stromversorgung
- **Fig.9**: eine primär getaktete Stromversorgung

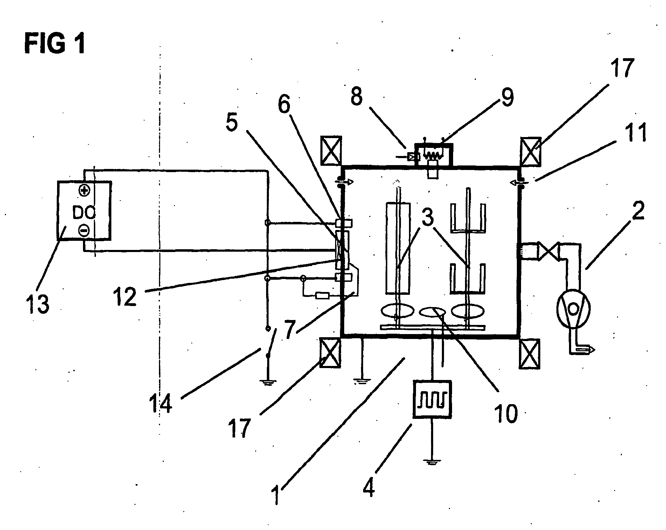

Die in Fig.1 dargestellte Vakuumbehandlungsanlage 1 zeigt vergleichsweise eine aus dem Stand der Technik bekannte Anordnung zum Betreiben einer Arcquelle mit einer DC-Stromversorgung 13. Die Anlage 1 ist mit einem Pumpstand 2 zum Erstellen des Vakuums, Substrathalterungen 3 zum Aufnehmen und elektrischen Kontaktieren der hier nicht näher dargesellten Werkstücke, sowie einer Biasstromversorgung 4, zum Anlegen einer sogenannten Substratspannung an die Werkstücke ausgerüstet. Letztere kann eine DC-, eine AC- oder eine bi- bzw. unipolare Substratspannungsversorgung sein. Über einen Prozessgaseinlas 11 kann Inert- bzw. Reaktivgas eingelassen werden, um Prozessdruck und Gaszusammensetzung in der Behandlungskammer zu steuern.

Bestandteile der Arcquelle selbst sind ein Target 5 mit dahinterliegender Kühlplatte 12, ein Zündfinger 7 sowie eine das Target umfassenden Anode 6. Mit einem Schalter 14, kann zwischen einem floatenden Betrieb der Anode und des positiven Pols der Stromversorgung 13 und einem Betrieb mit definiertem Null- bzw. Masse potential gewählt werden.

Weitere fakultative Merkmale der Vakuumbehandlungsanlage 1 sind eine zusätzliche Plasmaquelle 9, in diesem Fall eine Quelle zur Erzeugung eines NVB mit Heisskathode, mit Inertgaseinlass 8, eine Hilfsanode 10, sowie einer hier nicht näher dargestellten weiteren Stromversorgung zum Betreiben des Niedervoltbogens zwischen Plasmaquelle 9 und Hilfsanode 10, und bei Bedarf Spulen 17 zur magnetischen Bündelung des Niedervoltbogenplasmas.

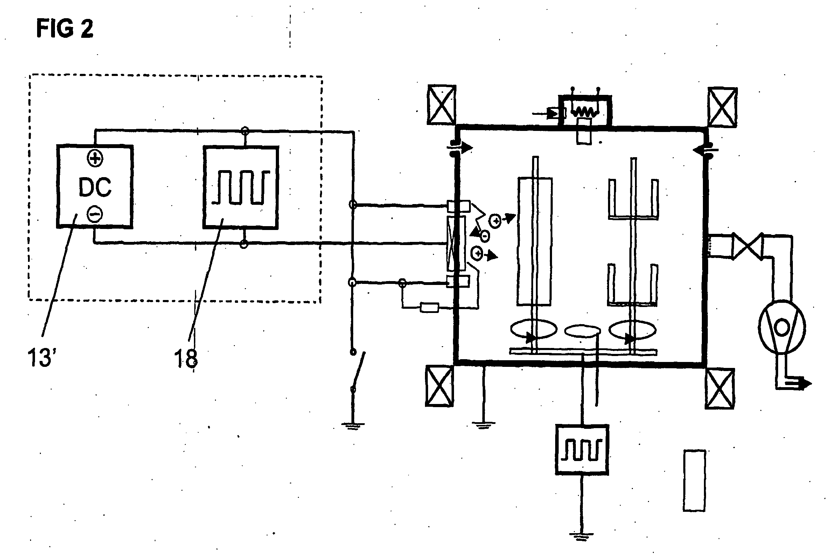

In Fig.2 ist eine Arcquelle dargestellt, die mit zwei parallel geschalteten Stromversorgungen, nämlich einer DC Stromversorgung 13' und einer gepulsten Hochstromversorgung 18, betrieben wird, um den Gleichstrom mit einem unipolaren oder bipolaren Pulssignal zu überlagern. Diese Beschaltung erlaubt einen stabilen Betrieb einer reaktiven Funkenverdampfung auch für isolierende Schichten, bei denen sich im Zeitverlauf das Innere der Anlage 1, die Hilfsanode 10 und die Substrathalterungen 3 mit Substraten mit einer isolierenden Schicht belegen.

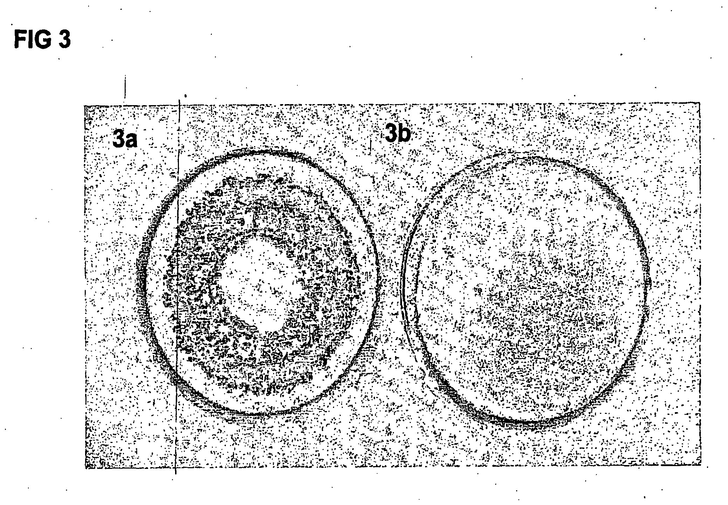

Wird vergleichsweise ein Target 5 aus reinem Aluminium in einer argon- und sauerstoffhaltigen Atmosphäre lediglich mit einer DC-Stromversorgung 13 gemäss Fig.1 betrieben, kommt es bereits nach wenigen Minuten zu Prozessinstabilitäten die bei hohem Sauerstoffluss zum Prozessabbruch führen. Dabei bildet sich auf dem Target 5 eine wie in Fig.3a dargestellte Belegung mit mehreren Millimeter grossen Inseln aus isolierendem Material. Die auf den Werkstückoberflächen abgeschiedenen Schichten werden sehr rauh und nicht vollständig isolierend, da es offenbar nicht zu einer durchgehenden Reaktion der vielen metallischen Spritzer kommt. Wird hingegen ein Target 5 in sauerstoffhaltiger Atmosphäre unter sonst gleichen Bedingungen mit einem erfindungsgemässen Verfahren wie in Fig.2 betrieben, bildet sich eine isolierende aber völlig gleichmässige Aluminiumoxidoberfläche wie in Fig.3b gezeigt. Der Prozess kann über Stunden geführt, unterbrochen und mit solcherart vergiftetem Target wiederaufgenommen werden. Gleichzeitig kommt es zu einer wesentlichen Reduktion der Spritzer auf der Werkstückoberfläche.

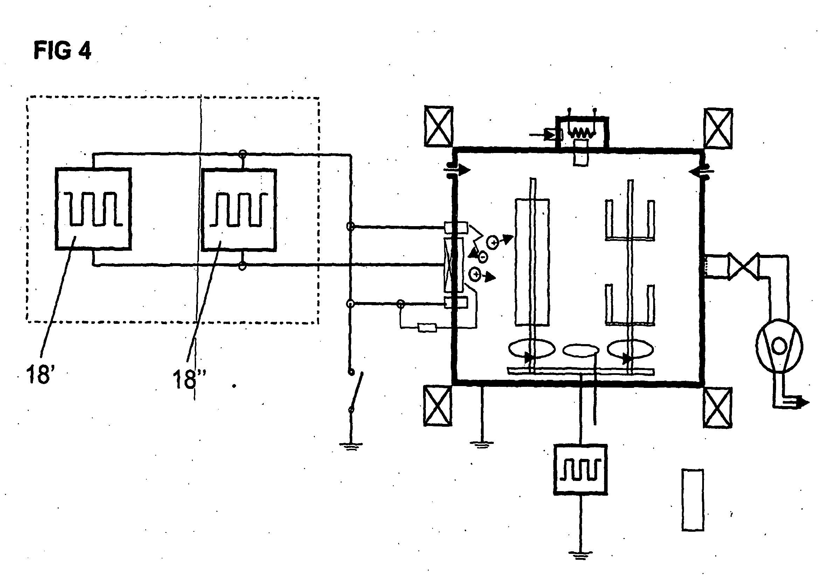

Im Folgenden werden weitere Möglichkeiten und Anordnungen zum pulsmodulierten Betreiben einer Arcquelle angeführt. Fig.4 zeigt die Parallelschaltung zweier bevorzugt synchronisiert gepulster DC Stromversorgungen 18' und 18". Diese Anordnung hat beispielsweise im unipolaren Betrieb eine Reihe von Vorteilen. So kann bei einem Betrieb mit gleicher Pulsbreite die Zeit zwischen zwei Pulsen sehr kurz gewählt werden, womit auch ein entsprechend grosses Tastverhältnis bzw. eine sehr kurze Zyklusdauer einstellbar ist. Durch die damit verbundene Möglichkeit die Energiezufuhr pro Puls, beispielsweise auch in Abstimmung auf das spezifische Targetmaterial, zu begrenzen, kann ein Festbrennen des Funkens sehr wirkungsvoll vermieden und einer Spritzerbildung weiter entgegengewirkt werden. Aber auch bei unipolarem Betrieb mit unterschiedlichen Pulsbreiten und verschiedenen oder gleichen Frequenzen, ermöglicht ein solcher Betrieb eine besonders gute Einstellung der einzelnen Zyklusphasen und damit eine sehr gute Kontrolle der Beschichtungsrate. Prinzipiell können gepulsten DC Stromversorgungen auch durch günstigere Wechselstromversorgungen ersetzt werden. Allerdings ist es dabei beispielsweise schwieriger, Signale einer bestimmten Form und Flankensteilheit zu erzielen.

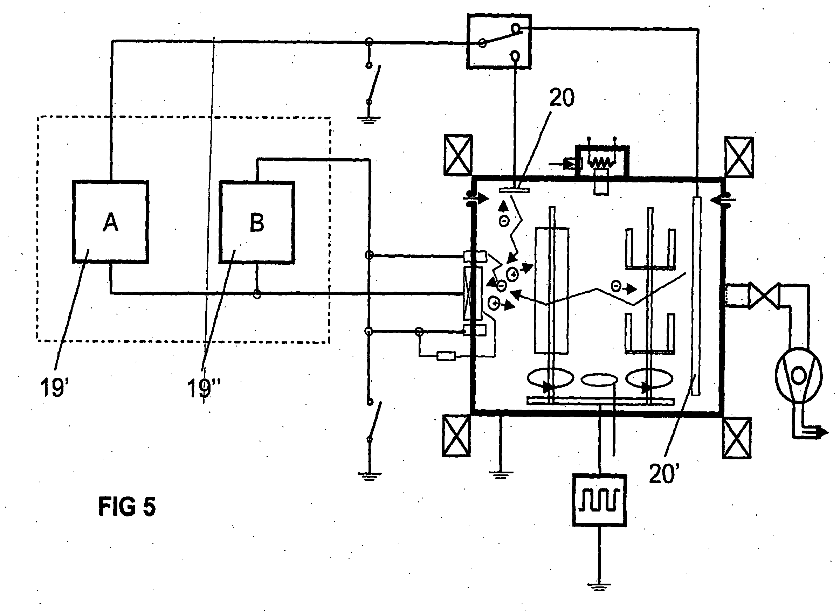

Gleichzeitig ermöglicht das Konzept zweier Stromversorgungen 19, 19" besonders vorteilhaft, wie in Fig.5 30 gezeigt, die Platzierung mehrerer Anoden 20, 20' zu einer besseren Verteilung des Plasmas in der Beschichtungskammer. Damit können die Elektronen besser geführt und damit die Plasmadichte und Reaktivität des Prozesses erhöht werden.

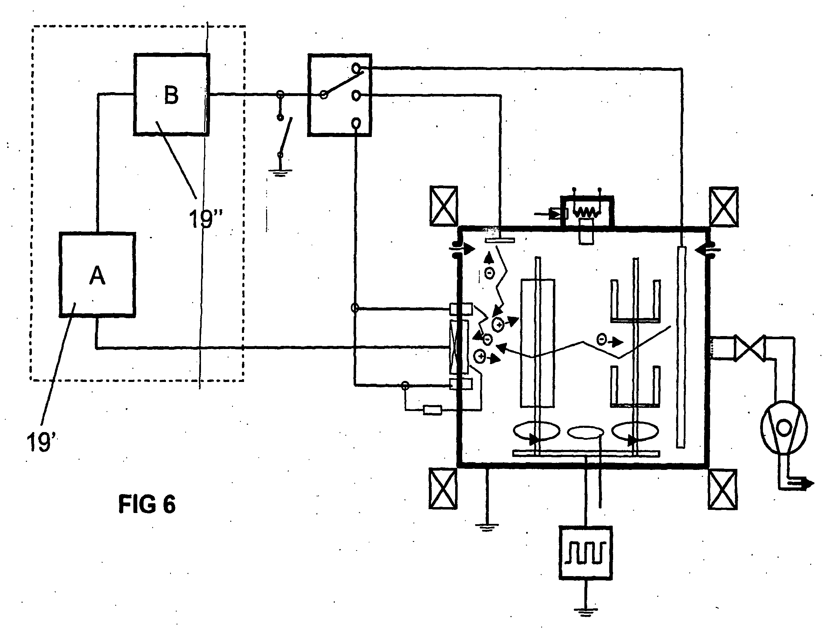

In Fig.6 wird eine Arcquelle dargestellt, die durch zwei in Serie geschaltete Stomversorgungen 19', 19", von denen zumindest eine eine Puls- bzw. AC-Versorgung ist, gespeist wird. Mit dieser Anordnung kann eine Anpassung der Rateregelung der Arcquelle besonders leicht realisiert werden kann.

Die weiteren Figuren betreffen Stromversorgungen, bei denen der Pulsstrom oder der Gleichstromanteil mittels Schaltnetzteiltechnik erzeugt wird. Bei derartigen Stromversorgungen kann die sonst nicht erwünscht Welligkeit des resultierenden DC-Signals solcherart verstärkt werden, dass ein den oben beschriebenen Anforderungen entsprechendes Signal am Ausgang der Stromversorgung anliegt.

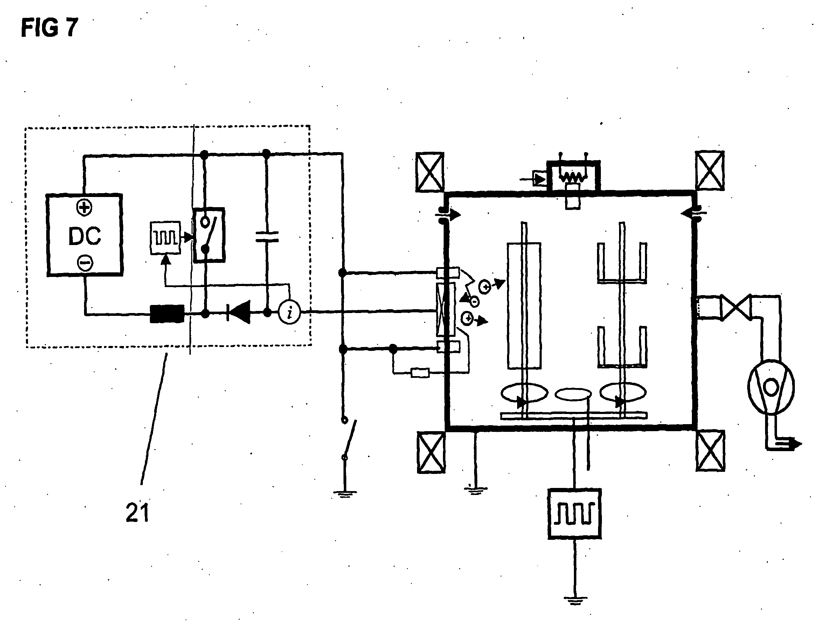

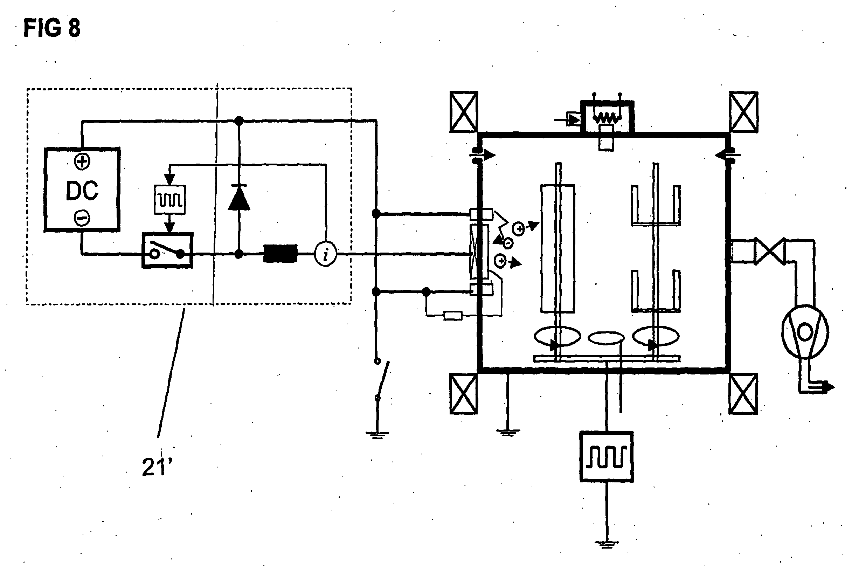

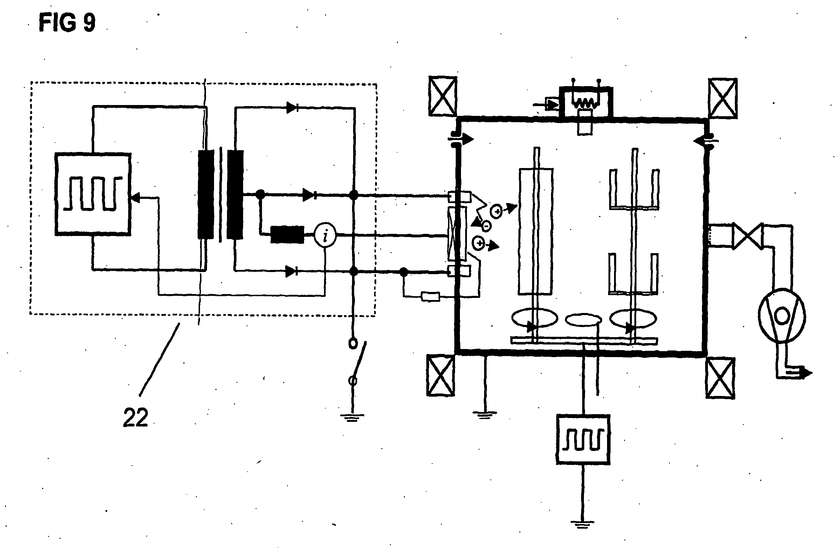

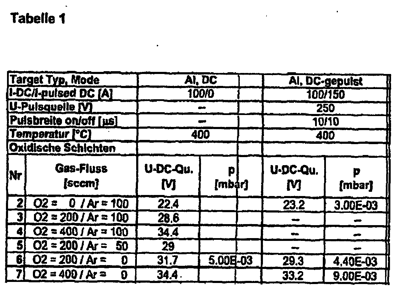

Beispielsweise kann dabei, wie in Fig. 7 schematisch dargestellt, eine sekundär getaktete Stromversorgung als Aufwärtswandler 21 oder wie in Fig.8 eine ebenfalls sekundär getaktete Stromversorgung als Abwärtswandler 21' verwendet werden. Fig.9 zeigt hingegen eine primär getaktete Stromversorgung 22 zur Erzeugung des gewünschten Signals.

Von allen Versorgungen mit Schaltnetzteiltechnik ist die in Fig.8 gezeigte Versorgung die, die mit dem geringsten technischen Aufwand zu realisierbar ist und wird d.h. bevorzugt angewendet.

### Bezugszeichenliste

- 1: Vakuumbehandlungsanlage
- 2: Pumpstand
- 3: Substrathalterung
- 4: Biasstromversorgung
- 5: Target
- 6: Anode
- 7: Zündfinger
- 8: Inertgaseinlass
- 9: Plasmaquelle
- 10: Hilfsanode
- 11: Prozessgaseinlass
- 12: Kühlplatte
- 13,13': DC Stromversorgung
- 14: Schalter
- 17: Magnetspulen
- 18,18',18": Pulsstromversorgung
- 19,19',19": Stromversorgung
- 20,20': Anode
- 21: Aufwärtswandler
- 21': Abwärtswandler
- 22: primär getaktete Stromversorgung

## Patentansprüche

1. Verfahren zum Betreiben einer Arcquelle, wobei eine elektrische Funkenentladung innerhalb einer Atmosphäre, welche ein Reaktivgas umfasst, auf einer Oberfläche eines Targets (5) gezündet bzw. betrieben wird, wobei die Funkenentladung gleichzeitig mit einem Gleichstrom als auch mit einem Puls- bzw. Wechselstrom gespeist wird, **dadurch gekennzeichnet, dass** die Oberfläche des Targets (5) zumindest teilweise durch eine Isolierbelegung, welche durch Betreiben der Arcquelle in der reaktivgashaltigen Atmosphäre, aus einer Reaktion zwischen dem Reaktivgas und dem verdampften Material des Targets (5), gebildet wird, bedeckt ist, wobei durch die Isolierbelegung eine Erhöhung des DC-Anteils der Quellenspannung zumindest 20% gegenüber dem Betrieb mit einer Oberfläche ohne Isolierbelegung bewirkt wird, wobei als Reaktivgas Sauerstoff und als Targetmaterial Aluminium eingesetzt werden.

## Claims

1. Method for operating an arc source, in which an electrical spark discharge within an atmosphere which comprises a reactive gas is ignited or operated on a surface of a target (5), with the spark discharge being fed at the same time with a direct current and with a pulsed or alternating current, **characterized in that** the surface of the target (5) is at least partially covered by an insulating coating which is formed by operating the arc source in the atmosphere containing reactive gas, from a reaction between the reactive gas and the vaporized material of the target (5), with the insulating coating resulting in an increase in the DC component of the source voltage by at least 20% in comparison to operation with a surface without an insulating coating, with oxygen being used as reactive gas and aluminium being used as target material.

## Revendications

1. Procédé d'utilisation d'une source d'arc, dans lequel une décharge électrique à étincelles à l'intérieur d'une atmosphère comprenant un gaz réactif est amorcée ou utilisée sur une surface d'une cible (5), dans lequel la décharge à étincelles est alimentée simultanément en un courant continu ainsi qu'en un courant pulsé ou alternatif, **caractérisé en ce que** la surface de la cible (5) est couverte au moins en partie par un revêtement isolant qui est formé par l'utilisation de la source d'arc dans l'atmosphère contenant du gaz réactif, à partir d'une réaction entre le gaz réactif et le matériau vaporisé de la cible (5), dans lequel une augmentation de la part de courant continu de la tension de source d'au moins 20 % par rapport à l'utilisation avec une surface sans revêtement isolant est causée par le revêtement isolant, de l'oxygène étant utilisé comme gaz réactif et de l'aluminium étant utilisé comme matériau de cible.
